# EUROPEAN PATENT SPECIFICATION

(11) **EP 0 549 320 B1**
(45) Date of publication and mention of the grant of the patent: **04.10.2000**
(21) Application number: 92311688.3
(22) Date of filing: 22.12.1992
(51) Int. Cl.: H01L 27/02

(54) **Apparatus for ESD protection**
Vorrichtung für ESD-Schutz
Appareil pour la protection ESD

(30) Priority: 27.12.1991 US 815069
(43) Date of publication of application: 30.06.1993
(73) Proprietor: TEXAS INSTRUMENTS INCORPORATED, Dallas Texas 75265 (US)
(72) Inventor: Duvvury, Charvaka, Plano, Texas 75025 (US)
(74) Representative: Nettleton, John Victor

(56) References cited:
- EP-A- 0 055 552
- EP-A- 0 257 774
- WO-A-90/10952
- FR-A- 2 652 449
- US-A- 3 746 946
- US-A- 4 605 980
- US-A- 4 829 350
- US-A- 4 855 620
- PATENT ABSTRACTS OF JAPAN vol. 11, no. 312 (E-548)(2759) 12 October 1987
- PATENT ABSTRACTS OF JAPAN vol. 7, no. 84 (E-169)(1229) 8 April 1983
- PATENT ABSTRACTS OF JAPAN vol. 11, no. 182 (E-515)(2629) 11 June 1987
- PATENT ABSTRACTS OF JAPAN vol. 7, no. 284 (E-217)(1429) 17 December 1983

## Description

### BACKGROUND OF THE INVENTION

This invention relates to integrated circuits, and more particularly, relates to electrostatic discharge protection devices for incorporation into integrated circuits.

Electronic integrated circuits often fail when exposed to large and sudden electrostatic discharges. The manufacture and use of integrated circuits in equipment and by personnel may result in the build up of substantial amounts of charge dig the contact and subsequent removal of dissimilar materials from one another. The built up electrostatic charge may be quickly discharged when the charged items comes in contact with an integrated circuit, especially when portions of the circuit are connected to power supplies that have an equipment ground. Such discharges may cause significant damage to the integrated circuit by way of dielectric breakdown of oxides and other thin films and by high levels of conduction through relatively small areas of the circuit arising from reverse breakdown of P-N junctions of the circuit. If the diode enters the negative resistance region of its diode breakdown characteristics, sufficient conduction may occur to melt conductive material (such as polysilicon or aluminum), via resistive heating, causing especially damaging results. The molten material may then flow along the lines of the electric field associated with the device and create a short circuit, such as a source-to-drain short in a MOSFET. This short circuit will remain after the electrostatic discharge has been completed and is likely to render the integrated circuit useless.

To reduce the sensitivity of integrated circuits to electrostatic discharge ("ESD"), modern integrated circuits have been designed and manufactured to have protection devices at their external terminals. These protection devices are to provide a "safe" path for the electrostatic charge to follow. Such a safe path is designed in a manner that no damage occurs when electrostatic discharge occurs from a charged body to the associated terminal. These circuits have included the use of diffusion resistors and punch-through diodes. An example of such a protection device is the thick field oxide transistor described in U.S. Patent No. 4,692,781, issued September 8, 1987 and assigned to Texas Instruments Incorporated. An example of a protection device for complimentary metal-oxide-semiconductor (CMOS) integrated circuits is described in U.S. Patent No. 5,012,317 issued April 30, 1991 and assigned to Texas Instruments Incorporated.

For integrated circuit chips with CMOS or NMOS output buffers the ESD performance is most often limited by the NMOS pull-down device of the output buffer. For large NMOS output devices that have multiple parallel fingers, uniform conduction of all parasitic bipolar devices is difficult to achieve. This non-uniform conduction is discussed by T. Polgreen and A. Chatterjee in, "Improving the ESD failure threshold of silicided NMOS output transistors by insuring uniform current flow," EOS/ESD Symposium Proceedings, Vol. EOS-11, pp. 167-174 (1989). For the case of grounded substrate logic chips, this can lead to very low ESD performance, especially if advanced process technologies that include silicided diffusion are used. As a result, much of the recent ESD design focus has been for output protection techniques.

Traditionally, output buffer circuits have not included ESD devices for various reasons. In integrated circuits having sufficiently large geometries, the transistors in the push-pull output buffer have been sufficiently large to safely handle the fairly large amounts of electrostatic discharge current that may be presented at the output terminal. The performance of the output terminal relative to electrostatic discharge protection was thus often better than the input terminals of the device. Improvements in ESD protection for the input terminals of integrated circuits beyond the protection provided by the push-pull output drive circuit has shifted the emphasis of electrostatic discharge protection back to the output buffer. Process advancements have also contributed to the degradation of an output circuit's ESD levels.

The output buffer may be provided with an improved ESD tolerance by incorporating a field oxide (or other high threshold voltage) transistor, having its source-to-drain path connected between the ground and the gate of the pull-down transistor, and having its gate connected to the output terminal. An example of such an output buffer having improved ESD tolerance is described in U.S. Patent No. 4,855,620, issued August 8, 1989 and assigned to Texas Instruments Incorporated. This patent describes a thin oxide NMOS output device coupled with a field oxide device to ground the gate of the thin oxide device during ESD and help improve the ESD protection level. The grounding of the gate was an attempt to suppress the MOSFET channel conductions while the parasitic bipolar (npn) device discharged the electrostatic stress current. However, such grounded gate MOSFETs have turned out to be not very reliable.

These and other limitations and disadvantages of the prior art are overcome by the present invention, however, and improved methods and apparatus are provided for ESD protection of integrated circuits.

### SUMMARY OF THE INVENTION

The apparatus of the present invention employs a field oxide device and an NMOS device whose gate is connected to the drain of the field oxide device. The sources of the NMOS and the field oxide devices are connected to ground, while both the drain of the NMOS device and gate of the field oxide device are connected to an output, input, or other signal terminal to be protected from ESD events. In addition, preferably an N-well resistor is connected between the gate of the NMOS device and ground.

The operation of the apparatus of the present invention is involved with simultaneous MOS/bipolar conduction. For an ESD pulse, the voltage at the drain of the NMOS and at the gate of the field oxide device both increase. Due to capacitive coupling between the drain and gate of the NMOS device, the MOSFET gate potential also increases, by an amount depending upon the field oxide device size. When the turn-on threshold voltage of the field oxide device is reached, the field oxide device will turn on, ground its drain via the grounded source, and thereby discharge the MOSFET gate to ground. Prior to this, the NMOS device with its gate at 1-2 volts and its drain at 10 to 12 volts, will be under high substrate current conditions due to impact ionization at the drain. The resultant hole injection into the substrate will forward bias the MOSFET source junction and thereby uniformly turn on the lateral fingers of the parasitic npn device for efficient ESD protection. The N-well resistor serves to discharge any non-ESD charge buildup on the gate of the NMOS device to ground.

It is an object of the present invention to provide an improved ESD protection device for NMOS or CMOS technologies.

US-A-4 855 620 discloses an output buffer with ESD protection. In an n-channel MOS push-pull output buffer circuit, the gates of both pull-up and pull-down transistors are biased to hold them off during a positive polarity ESD event but otherwise they function normally. The pull-down transistor is an n-channel transistor constructed as transistor 2 of the present Figures 1 and 2 (which appear also in US-A-4 855 620) and has its source connected to Vₛₛ (ground) and its drain connected to a pad. The pull-up transistor is a similarly constructed n-channel transistor having its drain connected to the positive power supply voltage V_{dd} and its source connected to the pad.

For ESD protection, an n-channel transistor, preferably a field oxide transistor, having a threshold voltage higher than the power supply voltage has its source connected to Vₛₛ, its drain connected to the gate of the pull-down transistor, and its gate connected to the pad, and a further n-channel high threshold transistor has its source connected to the gate of the pull-up transistor, its drain connected to V_{dd}, and its gate connected to the pad.

EP-A-0 055 552 discloses an input protection circuit for an MIS circuit. Two resistors are connected in series between an input terminal and the gate of the MIS transistor. A first protection transistor is connected between the junction of the two resistors and a ground power supply line. A second protection transistor is connected between the junction of the protected transistor and one of the resistors, and the high power supply line. The second protection transistor has a break-down voltage lower than the breakdown voltage of the protected transistor but a high impedance when turned ON when a high voltage is applied to the input terminal. The first protection transistor has a breakdown voltage higher than that of the protected transistor but has a low impedance when turned On when a high voltage is applied to the input terminal.

In another example, second protection means is connected between the junction of the protected transistor and one of the resistors, and ground power supply. This second protection means comprises a second protection transistor having a drain connected to the last-mentioned junction, a source connected to the ground power supply, and a gate connected to the ground power supply by way of a further transistor

The present invention provides an integrated circuit as defined in claim 1.

It is an object of the present invention to provide an improved and effective output ESD protection device for grounded substrate logic chips with advanced technologies of LDD and silicided diffusions.

It is an object of the present invention to provide an ESD protection device for inputs with no secondary protection required.

It is an object of the present invention to provide an ESD protection device for inputs with fast input signal propagation.

It is an object of the present invention to provide an ESD protection device for inputs that minimizes CMOS latch-up susceptibility.

It is an object of the present invention to provide an ESD protection device for power bus lines for internal ESD protection.

It is an object of the present invention to provide an ESD protection device for outputs that minimize latent ESD effects in subsequent hot carrier degradation of output buffer devices.

These and other objects and advantages of the present invention will become apparent from the following detailed description, wherein reference is made to the figures in the accompanying drawings.

### BRIEF DESCRIPTION OF THE DRAWINGS

Figure 1 is a cross-sectional diagram of an N-channel pull-down transistor of an output buffer constructed by conventional methods.
Figure 2 is a cross-sectional diagram of an N-channel pull-down transistor having clad diffusions constructed by conventional methods, illustrating channel inversion resulting from capacitive coupling of an ESD pulse to the gate.
Figure 3 is an electrical diagram, in schematic form, of the ESD apparatus of the present invention connected to an output buffer.
Figure 4A depicts a drain waveform and a gate waveform for an NMOS device during an ESD event.
Figure 4B depicts current versus voltage waveforms for an NMOS device during an ESD event.
Figure 5A is an electrical diagram, in schematic form, of the ESD apparatus of the present invention connected to the input buffer of a device.
Figure 5B is an electrical diagram, in schematic form, of the ESD apparatus of the present invention used for internal protection between two voltages.
Figure 6 is a cross-sectional diagram of an NMOS device and a metal gate field oxide device which may be used as the apparatus of the present invention.

### DETAILED DESCRIPTION OF THE INVENTION

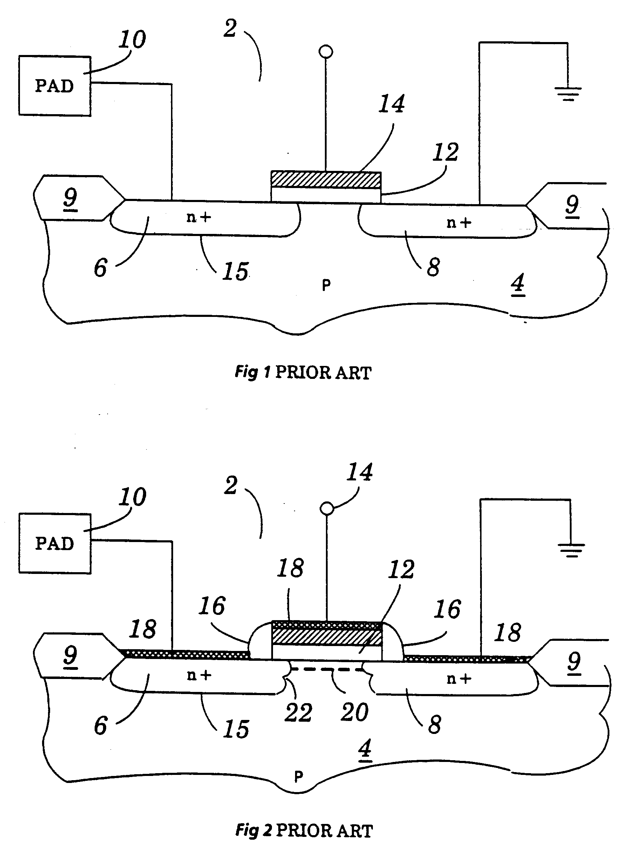

Referring now to Figure 1, there may be seen a conventional N-channel MOS transistor 2, used as the pull-down transistor in an output buffer. Transistor 2 is constructed in p-type substrate 4. This substrate 4, may, of course, alternatively be formed by epitaxial layer growth upon a substrate 4, or even by a p-type well diffused into an n-type substrate or epitaxial layer, such as in a CMOS device. The drain 6 and source 8 of transistor 2 are formed by n-type diffusions into the substrate 4. As is well known for a pull-down transistor, its source 8 is connected to ground, and its drain 6 is connected to the output terminal or pad 10. Field oxide layers 9 isolate the n-type diffusions of transistor 2 from neighboring transistors, in a manner well known in the art.

The channel region lying between the source and drain is covered by a gate dielectric 12, over which a gate terminal 14 is deposited and patterned. The gate dielectric 12 is generally silicon dioxide, while the gate terminal 14 is generally polycrystalline silicon. As is well known in the art, the drain 6 and source 8 regions are diffused after the gate dielectric 12 and the gate electrode 14 are in place, for self-alignment with the gate electrode 14. The metallization forming contacts to the gate electrode 14, drain region 6 and source region 8 are not shown in Figure 1 for the sake of simplicity.

In the event of a substantial voltage pulse (of a negative potential relative to ground) on the pad 10, such as may occur in an ESD event, transistor 2 is able to quickly handle the resultant current. Since the substrate 4 is generally biased to ground, or to a negative voltage, a negative voltage or drain 6 will forward bias the p-n junction 15 between the drain 6 and substrate 4. Accordingly, the charge applied to the pad 10 by the negative ESD event is safely conducted into substrate 4 without damage to transistor 2.

However, for a pulse (of a positive potential relative to ground) on the pad 10, the p-n junction 15 between the drain 6, and substrate 4 is reversed biased. A parasitic n-p-n bipolar transistor exists in the same structure, consisting of the drain 6 as its collector, the substrate 4 as its base, and the source 8 as its emitter. If the positive potential pulse is of sufficient magnitude, as can occur in an ESD event, the p-n junction 15 will break down. This breakdown will result in a current injected into the substrate 4 at the p-n junction 15, which provides sufficient base current for the parasitic n-p-n bipolar transistor to turn it on. If the voltage of the pad 10 resulting from the ESD event is sufficiently large to exceed the collector to base (with the emitter open) breakdown voltage of the parasitic n-p-n transistor, BV_{CBO}, the resultant breakdown current would be conducted from the pad 10 to the source region 8 connected to ground.

In such a breakdown, damage to transistor 2 may result from localized heating due to this breakdown current conduction. Such localized heating is determined by the product of the local current density and the electric field (J-E product). The J-E product is likely to be locally highest at the p-n junction 15 in a breakdown condition. The likelihood of damage to transistor 2 due to this condition will depend to a large degree upon the spacing separating the metallization (i.e., the source of metal filaments) from the point of localized heating at the p-n junction 15, *i.e.* the spacing between the metal contact to the drain 6 and the gate electrode 14.

Referring now to Figure 2, the construction of transistor 2 using the lightly-doped-drain, or graded junction, construction and using silicide-clad diffusions is illustrated. As is described in U.S. Patent No. 4,566,175, issued January 28, 1986 and assigned to Texas Instruments Incorporated, sidewall oxide spacers 16 may be formed along the edges of gate dielectric 12 and gate electrode 14, resulting in a shallower junction depth of the drain regions 6 and source regions 8 near the transistor channel region, as shown in Figure 2. In addition, it is also well known in the art to clad the exposed silicon in the drain region 6, source region 8, and gate electrode 14 with a silicide 18, such as titanium silicide. Titanium silicide formation is accomplished by way of a direct react process after deposition of a titanium layer, as is well known in the art and as described in U.S. Patent Nos. 4,384,301 and 4,545,116, both assigned to Texas Instruments Incorporated. The use of these advanced process techniques may result in reduced failure thresholds for ESD events. It is believed that the factors of (a) greater localized heating due to the increase in the J-E product at the surface of the channel region results from the shallower junction depth of the graded junction and (b) greater availability of melt material from the silicide layer 18 closer to the localized heating, contribute to the reduced ESD failure thresholds for these technologies.

In addition, some amount of capacitive coupling between the drain region 6 and the gate electrode 14 occurs in a positive polarity ESD pulse. This coupling of a positive voltage (relative to the substrate 4 and ground) onto the gate electrode 14 will tend to invert the channel region under the gate dielectric 12; such an inversion layer 20 is illustrated in Figure 2. Therefore, in addition to the condition resulting from a breakdown of the p-n junction 15 and the resultant bipolar conduction as described above, some MOS surface conduction may also occur through transistor 2. The combination of the concentration of bipolar conduction and MOS conduction at the surface of transistor 2 increases the localized J-E product at a point 22 close to the silicide layer 18. The likelihood of failure for an ESD event of a given magnitude is therefore significantly increased due to the use of silicide layer 18 and the graded junction.

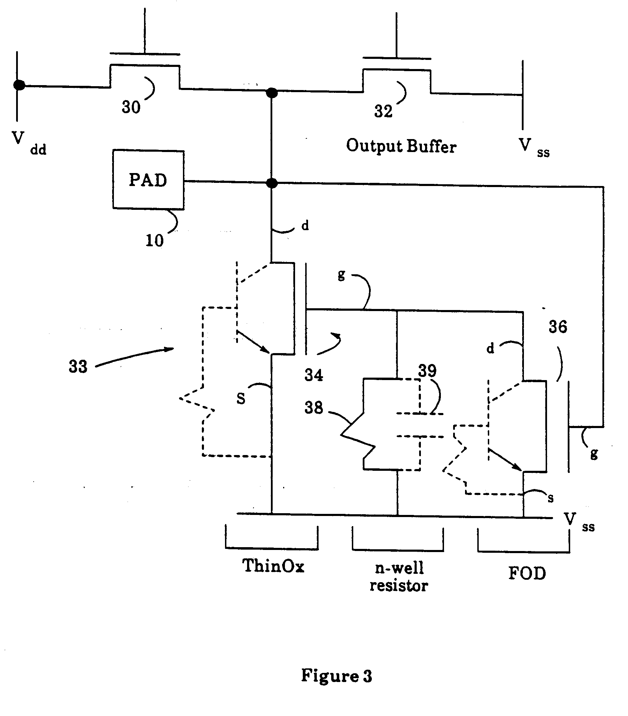

Referring now to Figure 3, a typical N-channel MOS push-pull output buffer circuit 30, 32 having improved ESD protection according to the teachings of the present invention is illustrated. As may be seen from Figure 3 the ESD apparatus 33 of the present invention is a separate circuit connected between the output and V_{SS} or ground of the output buffer 30, 32. This separate ESD protection circuit 33 only operates upon an ESD pulse and does not interfere with the normal operation of the output buffer. The ESD apparatus 33 of the present invention consists of an NMOS device 34 whose gate 34g is connected to the drain 36d of a field oxide device 36. The sources of the NMOS 34s and the field oxide 36s devices are connected to V_{SS} or ground, while the drain of the NMOS 34d and the gate of the field oxide 36d devices are connected to the output or pad 10.

In addition, preferably an N-well resistor 38 is connected to the gate 34g of the NMOS device and to V_{SS} or ground. This N-well resistor 38 has an inherent capacitance 39 associated with it. The RC constant of the resistor's resistance and capacitance should be long with respect to the rise time for ESD events while being short with respect to normal operating and measurement conditions.

When an ESD pulse strikes the pad 10, the voltages at drain 34d of the NMOS and the gate 36g of the field oxide device both increase. The dotted line components in Figure 3 illustrate how the solid line components operate during an ESD event. The N-well resistor 38 is solid since it may also operate during non-ESD events. Due to capacitive coupling between the drain 34d and gate 34g of the NMOS device, the MOSFET gate 36g potential also increases, which can be about 1 to 2 volts, depending upon the size of the field oxide device 36 and the N-well resistor 38. As the size of the field oxide device 36 increases the capacitance between the substrate and the drain 36d of the field oxide device increases. This in turn, increases the capacitive coupling between the drain 34d and gate 34g of the NMOS device. When the turn-on threshold voltage of the field oxide device 36 is reached, the field oxide device 36 turns on and thereby discharges the MOSFET gate 34g to V_{SS} or ground.

Prior to this, however, the NMOS device 34, with its gate 34g at 1-2 volts and its drain 34d at 10 to 12 volts, will be under high substrate current conditions due to impact ionization at the drain. The resultant hole injection into the substrate will forward bias the MOSFET source junction, and uniformly turn on the lateral fingers of the npn device for efficient ESD protection. For grounded substrate logic chips this uniform turn on of all the fingers of a MOSFET output ladder structure is difficult to achieve with prior art devices. As a result, the ESD protection level from these prior art devices has been significantly lower than expected.

This problem becomes worse for silicided diffusions where the protection levels are only about 5 volts/µm of device size and can be limited to only two or three fingers of 100µm each which actually turn on for ESD pulses. This problem is discussed in the Polgreen and Chatterjee article noted earlier herein. That is, even a 1000µm wide device (using silicided diffusions) consisting of 10 fingers would give only 1500 volts of ESD protection instead of the expected 5,000 volts. For a floating substrate DRAM , the full protection may be expected because uniform turn on of all fingers is possible. That is, a small amount of substrate current can raise the substrate potential during an ESD event and turn on all lateral bipolar devices for uniform conduction. The present invention thus makes it possible for an NMOS device in grounded substrate logic to be as efficient for an ESD event as it would be in a floating substrate DRAM . The device may be optimized as discussed below.

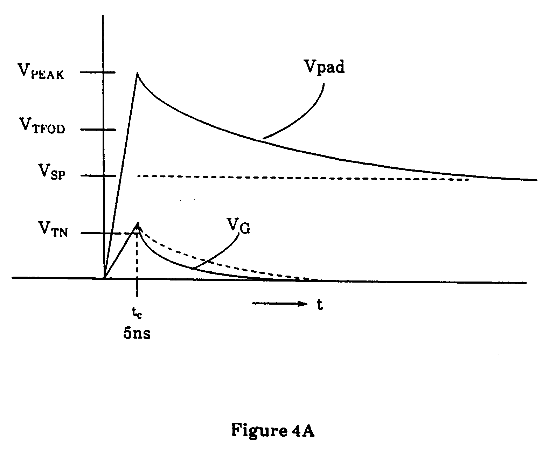

Representative drain (or pad) and gate voltage waveforms versus time for an NMOS device, V_{pad} and V_{G}, respectively, are shown in Figure 4A. Here V_{TN} is the turn on threshold voltage of the NMOS device, V_{TFOD}TFOD is he turn on threshold voltage of the field oxide device, and V_{Peak} and V_{SP} are drain avalanche and bipolar snapback voltages of the MOSFET, respectively. Optimum performance may be insured by selection of the proper width of the field oxide device. The field oxide device should be made large enough so that the MOSFET gate is turned off as soon as n-p-n snap-back is achieved. It should be small enough, on the other hand, such that the MOSFET gate is coupled higher to result in maximum substrate current. This optimization may be performed with a matrix of test structures employing the process used to manufacture the chip, *i.e.*, LDD, silicided diffusion, etc.

If the substrate potential can be locally increased during an ESD event by incorporating a momentary MOS action, better parasitic bipolar trigger can be achieved for the grounded substrate logic devices also. This requires dynamic gate coupling. It is obvious that gate coupling to slightly above the NMOS device's turn on threshold voltage (V_{TN}) will minimize the breakdown voltage and hence increase the efficiency of the finger turned on. This is because, in contrast to the grounded gate case, even if only one finger turned on first, the voltage buildup has to be small before the trigger of subsequent fingers, thus ensuring all of them rapidly participate before the device failure current is reached; the voltage buildup is small because the npn breakdown voltage is a function of the gate bias and decreases with increasing gate bias.

Thus, in general, the operation of the ESD apparatus of the present invention is as follows. With the ESD transient the NMOS gate is capacitively coupled upward and as soon as the MOS device goes through its snapback the gate is capacitively pulled down again, resulting in a transient pulse. The field oxide device provides the parasitic device to limit the maximum NMOS gate voltage level. Also, at higher stress levels abnormally high voltage spikes (35-50 V as measured at the pad) will turn on the field oxide gate to control the NMOS gate transient. Otherwise, if the NMOS gate stays on too long after the npn snapback, the surface conduction may result in a premature device failure.

The N-well resistor is connected between the gate of the NMOS device and V_{SS} or ground. An N-well resistor may be constructed adjacent the NMOS and field oxide devices by techniques well known in the art. The N-well resistor will have an inherent capacitance to the substrate based upon the size of the N-well, and accordingly, may be adjusted, as well as the resistance of the resistor.

Generally, the resistance may be of the order of twenty-five Kohms, or so, and the capacitance of the order of .3 picofarads. Combined with the gate-to-substrate capacitance of the thin oxide device, this provides an RC time constant of greater than about 7.5 nanoseconds. Other resistances and capacitances may be employed and still be within the scope of the present invention. The resistor discharges any charge build up on the gate of the NMOS device to V_{SS} or ground. However, the NMOS must first discharge the ESD pulse before this occurs. Thus, the RC constant of the resistor must be long compared to the rise time of an ESD event, *i.e.* greater than about 5 nanoseconds. If the RC constant is too small, the circuit will behave as a grounded gate circuit and become unreliable in operation and never go to the failure level threshold it should.

Although the ESD apparatus of the present invention should only operate during an ESD event, it is possible for the gate of the NMOS device to build up a charge during normal operations, turn on and provide an output leakage to V_{SS} or ground. The N-well resistor serves to remove any such build up from the gate of the NMOS via V_{SS} or ground. To accomplish this the RC constant of the N-well resistor should be small compared to the time for normal output voltage transients, *i.e.* less than about 100 nanoseconds. That is, the RC constant is selected to make the apparatus look like a grounded-gate device.

More particularly, the RC constant should be long enough to not interfere with ESD event dissipation and yet be short enough to avoid the appearance of signal leakage. Since leakage is generally not of concern for outputs, the leakage consideration may be relaxed for output buffer applications.

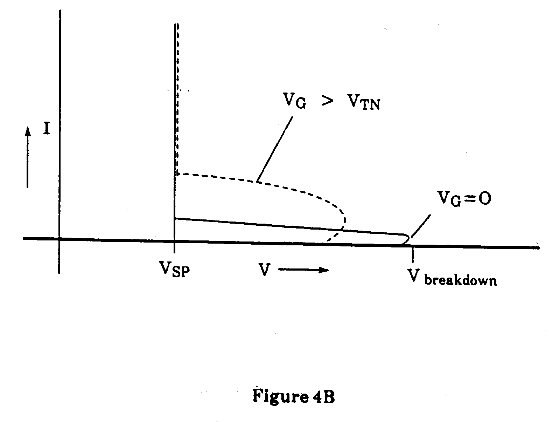

The controlled increase of MOSFET gate potential has other beneficial effects. Referring now to Figure 4B, it may be seen that, first, the drain breakdown voltage is reduced from the grounded gate (V_{G}=0) case. In Figure 4B, the dashed line depicts the drain breakdown voltage. The two curves of Figure 4B illustrate the dependence of breakdown voltage on the gate bias. The V_{G}=0 curve represents the grounded gate case and the V_{G}>V_{TN} curve represents the biased or coupled gate case. For the grounded gate case, there is very little or no conduction before snapback, while for the biased gate, any bias reduces the breakdown voltage and there is a lot of current before snapback occurs. This current (in the biased gate case) forward biases the fingers of the NMOS device and turns them on and holds the gate of all fingers "on." Each finger can only withstand a certain amount of current before failure and if only one or two fingers turn on (the grounded gate case), instead of all the fingers turning on (the biased gate case), the current will be excessive and those one or two fingers will be destroyed (or "blown-out"). This makes the device of the present invention particularly useful for application as an ESD protection circuit for outputs. That is, when placed in parallel with an output buffer (as depicted in Figure 3) it will turn on first and protect the output.

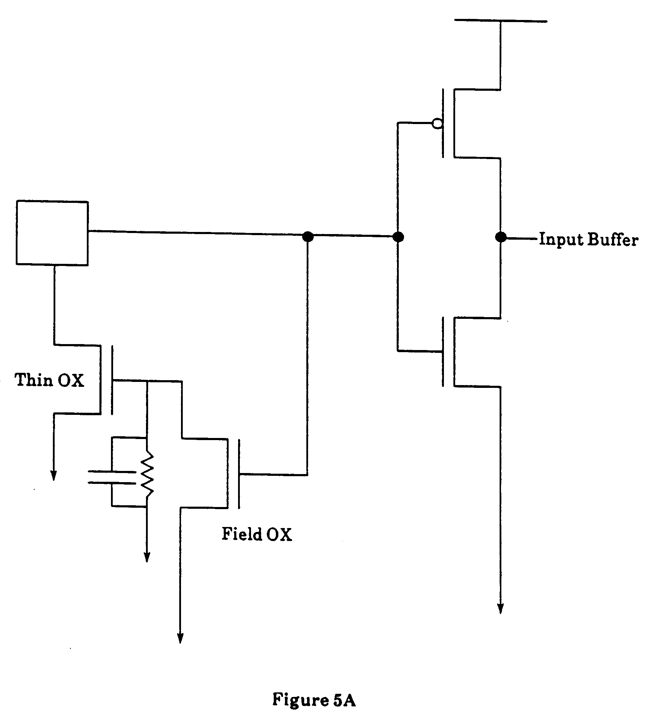

Similarly, the apparatus of the present invention may also be used for input ESD protection. Using this ESD protection device will eliminate the need for secondary protection that requires a resistance and hence the use of the present invention will improve the RC delay for input signals. That is, any input signal delay (associated with conventional ESD devices) will be minimized by use of the ESD apparatus of the present invention. Circuitry depicting the use of the apparatus of the present invention as an input ESD protection device is shown in Figure 5A.

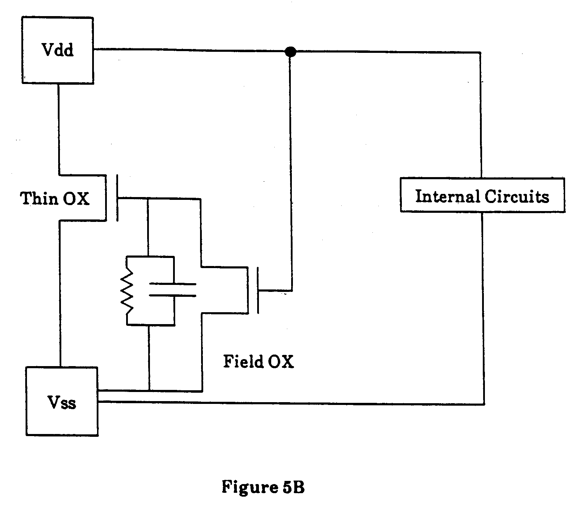

As noted in Figure 5B, this device may also be used for internal ESD protection between two voltages, V_{dd} and V_{SS}. The gate coupling would turn on this device before any parasitic npn or pnpn devices and offers excellent ESD protection.

The basic effectiveness of the apparatus of the present invention is improved by implementing a controlled amount of capacitance on to the gate of the NMOS device. Connecting the gate of the field oxide device will insure that the MOSFET conduction is suppressed after the lateral npn device(s) is (are) turned on.

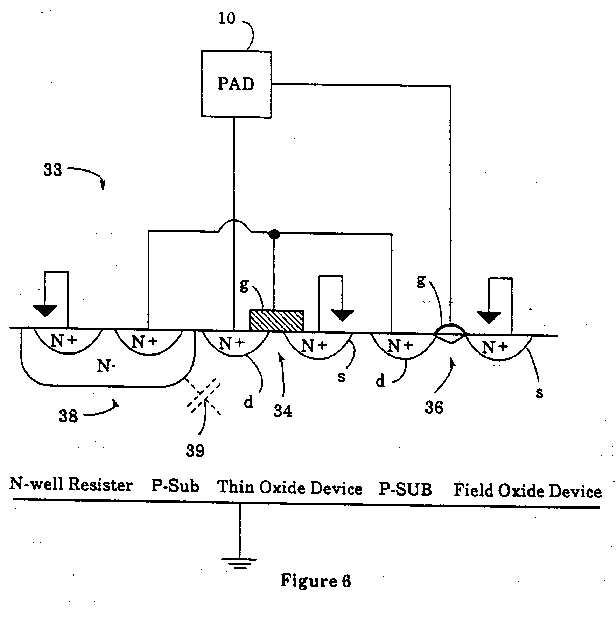

Referring now to Figure 6, the construction of one embodiment of the apparatus 33 of the present invention is illustrated. The transistors of Figure 6 are shown as conventional N-channel MOS transistors similar to those of Figure 1. The field oxide device 36 may be either a polysilicon gate field oxide device or a metal gate field oxide device. The field oxide transistor 36 is constructed using field oxide as the gate dielectric, and with a doped source region 36s as its source. As illustrated in Figure 3, the sources of both transistors 34 and 36 are biased to V_{SS} (which may be ground). The drain 36d of the field oxide transistor 36 is an n-type diffusion into a p-type substrate and the gate electrode 36g of the field oxide transistor 36 overlays the field oxide line between the source region 36s and drain region 36d. The gate electrode 36g is shown as a silicide-clad layer of polysilicon; of course, any known material for transistor gate electrodes may be employed, including aluminum and other metallization layers. The drain 36d of the field oxide device 36 is connected (by way of metallization or the like, not shown in Figure 6 for purposes of clarity) to the gate 34g of the thin oxide NMOS transistor 34 as shown in Figure 3. The field oxide gate electrode 36g and the drain electrode 34d of the thin oxide NMOS transistor 34 are connected to the pad 10, also as shown in Figure 3. By increasing the size of the field oxide device 36, the substrate capacitance is increased and correspondingly the gate 34g potential during an ESD event is increased.

The N-well resistor is made of two separate n⁺-type diffusions into an n⁻ well diffused into the p-type substrate. The resistance is adjusted by adjusting the number of squares (or size) of the lightly doped region. The capacitance of the resistor may be adjusted by selecting the appropriate side wall and bottom wall areas or dimensions.

Many other variations and modifications may be made in the apparatus and techniques hereinbefore described, by those having experience in this technology, without departing from the concept of the present invention. Accordingly, it should be clearly understood that the apparatus and methods depicted in the accompanying drawings and referred to in the foregoing description are illustrative only and are not intended as limitations on the scope of the invention.

## Claims

1. An integrated circuit comprising an integrated circuit portion (30,32) and an NMOS ESD circuit for protecting said integrated circuit portion (30,32);
both, the integrated circuit portion and the ESD circuit being connected to a signal terminal (10), the ESD circuit being arranged to operate upon an ESD event and not to interfere with the normal operation of the integrated circuit portion (30,32) the ESD protection circuit comprising:
a thin oxide transistor (34), having its drain-to-source path (d-s) connected between the signal terminal (10) and a reference voltage supply (Vₛₛ) and having a gate (g); and
a high threshold field oxide transistor (36), having a threshold voltage greater than a preselected power supply voltage, having its drain (d) connected to the gate (g) of the thin oxide transistor (34), having its source (s) connected to said reference voltage supply (Vₛₛ), and having its gate (g) connected to said signal terminal (10).

2. The ESD circuit of Claim 1, further comprising an N-well resistor (38) connected between said reference voltage supply (Vₛₛ) and said gate (g) of said thin oxide transistor (34).

3. The ESD circuit of any preceding claim, wherein said integrated circuit portion is an output buffer and said terminal (10) of said output buffer (30, 32).

4. The ESD circuit of any preceding claim, wherein said signal terminal is an input signal terminal of said integrated circuit.

5. The ESD circuit of any preceding claim, wherein said signal terminal is a voltage reference line of said integrated circuit.

6. The ESD circuit of any preceding claim, wherein the ESD circuit and the integrated circuit are formed in a semiconductor body.

## Patentansprüche

1. Integrierte Schaltung, die einen integrierten Schaltungsabschnitt (30, 32) und eine NMOS-ESD-Schaltung für den Schutz des integrierten Schaltungsabschnitts (30, 32) umfaßt; wobei beide, der integrierte Schaltungsabschnitt und die ESD-Schaltung, an einen Signalanschluß (10) angeschlossen sind, wobei die ESD-Schaltung so beschaffen ist, daß sie bei einem ESD-Ereignis arbeitet und den Normalbetrieb des integrierten Schaltungsabschnitts (30, 32) nicht stört;
wobei die ESD-Schutzschaltung umfaßt:
einen Transistor (34) mit dünnem Oxid, dessen Drain-Source-Pfad (d-s) zwischen den Signalanschluß (10) und eine Referenzspannungsversorgung (Vₛₛ) geschaltet ist und der ein Gate (g) besitzt;
einen Feldoxid-Transistor (36) mit hoher Schwelle, dessen Schwellenspannung höher als eine im voraus gewählte Leistungsversorgungsspannung ist, dessen Drain (d) an das Gate (g) des Transistors (34) mit dünnem Oxid angeschlossen ist, dessen Source (s) an die Referenzspannungsversorgung (Vₛₛ) angeschlossen ist und dessen Gate (g) an den Signalanschluß (10) angeschlossen ist.

2. ESD-Schaltung nach Anspruch 1, ferner mit einem N-Wannen-Widerstand (38), der zwischen die Referenzspannungsversorgung (Vₛₛ) und das Gate (g) des Transistors (34) mit dünnem Oxid geschaltet ist.

3. ESD-Schaltung nach einem vorhergehenden Anspruch, wobei der integrierte Schaltungsabschnitt ein Ausgangspuffer und der Anschluß (10) des Ausgangspuffers (30, 32) ist.

4. ESD-Schaltung nach einem vorhergehenden Anspruch, wobei der Signalanschluß ein Eingangssignalanschluß der integrierten Schaltung ist.

5. ESD-Schaltung nach einem vorhergehenden Anspruch, wobei der Signalanschluß eine Spannungsreferenzleitung der integrierten Schaltung ist.

6. ESD-Schaltung nach einem vorhergehenden Anspruch, wobei die ESD-Schaltung und die integrierte Schaltung in einem Halbleiterkörper gebildet sind.

## Revendications

1. Circuit intégré comprenant une partie de circuit intégré (30, 32) et un circuit de décharge électrostatique (ESD) NMOS permettant de protéger ladite partie de circuit intégré (30, 32); la partie de circuit intégré et le circuit de décharge électrostatique (ESD) étant tous les deux connectés à une borne de signal (10), le circuit de décharge électrostatique (ESD) étant fait pour fonctionner lors d'un événement de décharge électrostatique (ESD) et ne pas interférer avec le fonctionnement normal de la partie de circuit intégré (30, 32);
le circuit de protection contre les décharges électrostatiques (ESD) comprenant:
un transistor à oxyde mince (34), ayant son chemin drain-source (d-s) connecté entre la borne de signal (10) et une alimentation de référence (Vₛₛ) et ayant une grille (g); et
un transistor à oxyde de champ à seuil élevé (36), ayant une tension de seuil supérieure à une tension d'alimentation présélectionnée, ayant son drain (d) connecté à la grille (g) du transistor à oxyde mince (34), ayant sa source (s) connectée à ladite alimentation de référence (Vₛₛ), et ayant sa grille (g) connectée à ladite borne de signal (10).

2. Circuit de décharge électrostatique (ESD) selon la revendication 1, comprenant, en outre, une résistance à caisson de type N (38) connectée entre ladite alimentation de référence (Vₛₛ) et ladite grille (g) dudit transistor à oxyde mince (34).

3. Circuit de décharge électrostatique (ESD) selon l'une quelconque des revendication précédente , dans lequel ladite partie de circuit intégré est un tampon de sortie et ladite borne (10) dudit tampon de sortie (30, 32).

4. Circuit de décharge électrostatique (ESD) selon l'une quelconque des revendications précédentes, dans lequel ladite borne de signal est une borne de signal d'entrée dudit circuit intégré.

5. Circuit de décharge électrostatique (ESD) selon l'une quelconque des revendications précédentes, dans lequel ladite borne de signal est une ligne de référence de tension dudit circuit intégré.

6. Circuit de décharge électrostatique (ESD) selon l'une quelconque des revendications précédentes, dans lequel le circuit de décharge électrostatique (ESD) et le circuit intégré sont formés dans un corps semi-conducteur.
